# EUROPÄISCHE PATENTSCHRIFT

(11) **EP 3 644 019 B1**
(45) Veröffentlichungstag und Bekanntmachung des Hinweises auf die Patenterteilung: **27.01.2021**
(21) Anmeldenummer: 19184944.7
(22) Anmeldetag: 08.07.2019
(51) Int. Cl.: G01D 21/00, G08C 19/02

(54) **FELDMESSGERÄT**
FIELD MEASURING DEVICE
APPAREIL DE MESURE DE TERRAIN

(30) Priorität: 26.10.2018 DE 102018126808
(43) Veröffentlichungstag der Anmeldung: 29.04.2020
(73) Patentinhaber: KROHNE Messtechnik GmbH, 47058 Duisburg (DE)
(72) Erfinder: Brockhaus, Helmut, 46145 Oberhausen (DE); Dymek, Steffen, 48147 Oberhausen (DE); Fischnaller, Manuel, 44789 Bochum (DE)
(74) Vertreter: Gesthuysen Patentanwälte

(56) Entgegenhaltungen:
- EP-A1- 0 927 982
- DE-A1- 10 161 072
- DE-B3-102016 207 289
- US-A1- 2009 271 558

## Beschreibung

Die Erfindung betrifft ein Feldmessgerät mit einem Sensor, mit einem Messumformer und mit einer Schnittstellenelektronik, wobei die Schnittstellenelektronik eine Mess- und Steuervorrichtung und wenigstens einen ersten Anschluss und einen zweiten Anschluss zum Anschließen eines externen elektrischen Geräts aufweist.

Feldmessgeräte der beschriebenen Art werden seit Jahrzehnten in der Prozess- und Automatisierungstechnik eingesetzt, wobei sie zur messtechnischen Überwachung eines technischen Prozesses dienen, beispielsweise eines industriellen Produktionsprozesses. Feldmessgeräte sind - wie Feldgeräte allgemein - "im Feld" angeordnet, also in der unmittelbaren Prozessumgebung außerhalb von Schaltschränken oder Leitwarten. Sie sind deshalb häufig vergleichsweise rauen Umgebungsbedingungen ausgesetzt und sind üblicherweise entsprechend robust ausgebildet.

Das Dokument DE 101 61 072 A1 zeigt ein Beispiel für ein solches Feldmessgerät.

Der Sensor des Feldmessgeräts liefert einen Rohmesswert, in dem sich die eigentlich interessierende Messgröße widerspiegelt. Bei der interessierenden Messgröße kann es sich um eine beliebige Messgröße handeln, wie beispielsweise Volumen- oder Massedurchfluss, Temperatur, Druck, elektrische oder mechanische Spannungen, pH-Wert, Viskosität oder Dichte eines Mediums, Füllstand eines Behälters usw.; auf die konkrete interessierende Messgröße kommt es hier nicht an. Von dem Messumformer wird der Rohmesswert weiter bearbeitet und in eine besser weiterverarbeitbare - meist elektrische - Ausgangsgröße umgewandelt. Über die sich daran anschließende Schnittstellenelektronik ist es dem Feldmessgerät grundsätzlich möglich, mit einem externen elektrischen Gerät, wie zum Beispiel einer Leitwarte, Informationen auszutauschen.

Manche Beschreibungen des Standes der Technik ordnen die zuvor beschriebene Funktionalität vollständig dem Begriff "Messumformer" zu. Auch werden Vorrichtungen, die einen Messwert erfassen, wandeln und in einer geeigneten Form über eine Schnittstelle nach extern zur Verfügung stellen fachsprachlich als Transmitter bezeichnet.

Um ein externes elektrisches Gerät an das Feldmessgerät anschließen zu können, weist das Feldmessgerät bzw. die Schnittstellenelektronik wenigstens zwei Anschlüsse auf. Dabei kann es sich beispielsweise um die Anschlüsse einer Zweileiter-Schnittstelle handeln, mittels derer eine 4-20 mA-Stromschleife realisiert ist. Über die Schnittstellenelektronik können interne Daten des Feldmessgeräts, wie beispielsweise der Messwert, zu einem angeschlossenen externen elektrischen Gerät übertragen werden. Über die Schnittstellenelektronik kann es aber auch möglich sein, von einem angeschlossenen externen elektrischen Gerät Daten zu empfangen, die von der Schnittstellenelektronik entsprechend ausgewertet werden. Diese Informationen können zum Beispiel zur Konfiguration des Feldmessgerätes dienen. Es gibt Feldmessgeräte, bei denen die Schnittstellenelektronik als analoge Schnittstelle ausgebildet ist, um also ein analoges elektrisches Signal auszugeben bzw. zu empfangen, wozu beispielsweise die schon erwähnte 4-20 mA-Stromschnittstelle zählt. Die Schnittstellenelektronik kann aber auch dazu ausgebildet sein, Informationen in einer digitalen Technologie auszugeben oder zu empfangen. Dazu zählen beispielsweise HART-Schnittstellen und Puls- und/oder Frequenzschnittstellen.

Die Vielzahl an unterschiedlichen Möglichkeiten, die Schnittstelle eines Feldmessgeräts funktional zu belegen (Eingang, Ausgang, analog, digital/binär, Art der elektrischen Größe, passiv, aktiv), wird häufig durch alternative Hardwareausstattungen gelöst. Das Feldmessgerät eines bestimmten Typs und einer bestimmten Baureihe kann dann mit verschiedenen Schnittstellenoptionen ausgestattet werden, die sich untereinander ausschließen. Es kann auch vorgesehen sein, dass ein Feldmessgerät einer bestimmten Baureihe eine einheitliche Grundelektronik aufweist, also einen einheitlichen Sensor und einen einheitlichen Messumformer, dann aber - je nach Wunsch - eine entsprechende Schnittstellenelektronik vor Auslieferung des Geräts modular in die einheitliche Grundelektronik integriert wird, beispielsweise indem eine Platine mit der speziellen Schnittstellenelektronik auf eine Grundplatine mit der einheitlichen Grundelektronik aufgesteckt wird.

Insgesamt sind die dargestellten Vorgehensweisen zur Realisierung verschiedener Schnittstellenoption sehr aufwendig und wenig flexibel. Aufgabe der vorliegenden Erfindung ist es daher, ein Feldmessgerät anzugeben, bei dem die zuvor dargelegten Nachteile vermieden werden.

Die zuvor hergeleitete Aufgabe ist bei dem eingangs beschriebenen Feldmessgerät zunächst dadurch gelöst, dass bei der Schnittstellenelektronik in einem Anschlussstrompfad zwischen dem ersten Anschluss und dem zweiten Anschluss ein Stromregler und eine Strommessvorrichtung in Serie geschaltet sind. Zusätzlich ist vorgesehen, dass die Schnittstellenelektronik eine Spannungsquelle aufweist und die Spannungsquelle in den Anschlussstrompfad einschaltbar und aus dem Anschlusstrompfad heraustrennbar ist, sodass die Spannungsquelle im in den Anschlusstrompfad eingeschalteten Zustand und im Falle eines angeschlossenen externen elektrischen Geräts einen Strom in dem Anschlussstrompfad treiben kann. Darüber hinaus ist bei der Schnittstellenelektronik zusätzlich vorgesehen, dass die Mess- und Steuervorrichtung den Stromregler, die Strommessvorrichtung und die Spannungsquelle so ansteuert und ausliest, dass über den ersten Anschluss und den zweiten Anschluss bei angeschlossenem externen Gerät wahlweise ein analoges Stromsignal oder ein binäres Stromsignal ausgegeben oder eingelesen wird.

Mit dem zuvor beschriebenen Feldmessgerät ist es also aufgrund der besonderen Ausgestaltung der Schnittstellenelektronik möglich, vier verschiedene Schnittstellenfunktionalitäten zu realisieren, nämlich das Ausgeben eines analogen Stromsignals, das Ausgeben eines binären Stromsignals, das Einlesen eines analogen Stromsignals und das Einlesen eines binären Stromsignals. Die Schnittstellenelektronik ist damit äußerst flexibel und die Realisierung sowie das Vorhalten verschiedener Hardwarevarianten für das Feldmessgerät bzw. die Schnittstellenelektronik entfallen.

Über den Stromregler im Anschlussstrompfad ist es möglich, den Strom im Anschlussstrompfad zu regeln. Die in den Anschlussstrompfad einschaltbare und aus dem Anschlusstrompfad heraustrennbare Spannungsquelle ermöglicht es dem Feldmessgerät bedarfsweise einen Strom aktiv in dem Anschlusstrompfad zu treiben, sofern ein externes Gerät an dem ersten Anschluss und dem zweiten Anschluss angeschlossen ist. Das externe Gerät treibt dann aber selbst keinen Strom in der Stromschleife, die es mit dem Feldgerät bildet. Die Spannungsquelle im Feldgerät muss nicht dauerhaft in den Anschlussstrompfad eingeschaltet sein, die Spannungsquelle muss funktional in den Anschlussstrompfad jedenfalls zumindest einschaltbar sein für den Fall, dass von der Spannungsquelle Strom in dem Anschlussstrompfad getrieben werden soll.

Die Spannungsquelle könnte also beispielsweise mit einer Schaltvorrichtung aus dem Anschlussstrompfad elektrisch herausgetrennt werden, mit der die Spannungsquelle von der Mess- und Steuervorrichtung praktisch zu- und abgeschaltet werden kann.

Hinsichtlich der Realisierung eines analogen Stromeingangs zeichnet sich eine bevorzugte Ausgestaltung des erfindungsgemäßen Feldmessgeräts dadurch aus, dass die Strommessvorrichtung in dem Anschlussstrompfad den Istwert Iᵢₛₜ des Stroms im Anschlussstrompfad erfasst. Vorzugsweise ist die Strommessvorrichtung zur Erfassung des Stroms im Anschlussstrompfad als elektrischer Widerstand ausgebildet, vorzugsweise als ohmscher elektrischer Widerstand. Der Spannungsabfall über dem Widerstand wird dann als Maß für den Strom im Anschlussstrompfad von der Mess- und Steuervorrichtung ausgewertet. Vorzugsweise wird der Spannungsabfall durch einen Analog/Digital-Wandler in einen entsprechenden digitalen Datenwert gewandelt und digital weiterverarbeitet. Selbstverständlich kann auch der analoge Wert des Spannungsabfalls von der Mess- und Steuervorrichtung erfasst und weiterverarbeitet werden.

Zur Realisierung des Einlesens eines analogen Stromsignals ist weiter vorgesehen, dass für die Messung des analogen Stromsignals -insbesondere wenn es von extern getrieben wird, also von einem angeschlossenen externen Gerät - durch die Mess- und Steuervorrichtung der Stromregler und die Spannungsquelle deaktiviert werden. Mit diesen Maßnahmen wird sichergestellt, dass ein von extern über den ersten Anschluss und den zweiten Anschluss der Schnittstellenelektronik in den Anschlussstrompfad getriebener Strom möglichst unbeeinflusst und unverfälscht bleibt. In diesem Sinne ist auch der Begriff "deaktiviert" zu verstehen. Wenn der Stromregler beispielsweise als ein einstellbarer elektrischer Widerstand in dem Anschlussstrompfad realisiert ist, dann wird der Stromregler deaktiviert, indem er möglichst weit aufgesteuert wird. Der Stromregler könnte auch funktional deaktiviert werden, indem er in dem Anschlussstrompfad elektrisch überbrückt wird und damit praktisch keine Wirkung mehr hat.

Wenn von extern über die Anschlüsse der Schnittstellenelektronik in den Anschlussstrompfad ein Strom getrieben wird, ist eine Einflussnahme der Spannungsquelle unerwünscht. Die Spannungsquelle könnte daher durch die Mess- und Steuervorrichtung deaktiviert werden, indem die Spannungsquelle mittels einer Schaltvorrichtung aus dem Anschlusstrompfad elektrisch herausgetrennt wird, sodass über die Spannungsquelle kein Strom mehr in dem Anschlussstrompfad treiben kann.

Hinsichtlich der Realisierung der Ausgabe eines insbesondere analogen Stromsignals ist in einer bevorzugten Ausgestaltung vorgesehen, dass der Stromregler als Stellglied einen steuerbaren elektrischen Widerstand, insbesondere auf Halbleiterbasis, im Anschlussstrompfad aufweist. Es ist einleuchtend, dass durch Variation des Widerstandwertes des elektrischen Widerstandes auf den Stromfluss im Anschlussstrompfad Einfluss genommen werden kann. Hierzu wird ein Istwert Iᵢₛₜ für den Strom im Anschlussstrompfad erfasst, wobei dieser Istwert insbesondere von der Strommessvorrichtung bereitgestellt wird. Der Istwert Iᵢₛₜ wird mit einem vorgegebenen Sollwert Iₛₒₗₗ für den Strom im Anschlussstrompfad verglichen. Der steuerbare elektrische Widerstand wird dann so angesteuert, dass die Regeldifferenz aus Sollwert Iₛₒₗₗ und Istwert Iᵢₛₜ für den Strom im Anschlussstrompfad verkleinert wird, insbesondere zu null geregelt wird.

Bei dem Steuerbaren elektrischen Widerstand kann es sich um einen Transistor handeln, vorzugsweise um ein Bipolartransistor besonders bevorzugt jedoch um einen Feldeffekttransistor, da Transistoren der letztgenannten Gruppe eine geringere Temperaturabhängigkeit aufweisen (das gilt insbesondere für MOS-FET). Zur Erfassung der Regeldifferenz und zum Ansteuern des Transistors wird dann vorzugsweise ein Operationsverstärker verwendet, wobei der Ausgang des Operationsverstärkers die Steuerelektrode des verwendeten Transistors ansteuert (Basis des Bipolartransistors, Gate des Feldeffekttransistors). Der Vorgabewert für den Strom im Anschlussstrompfad, also der Sollwert Iₛₒₗₗ, wird zumindest mittelbar von der Mess- und Steuervorrichtung in Form einer Spannung vorgegeben und auf einen - den positiven - Eingang des Operationsverstärkers gegeben. Der Istwert Iᵢₛₜ des Stromes wird in Form einer elektrischen Spannung auf den negativen Eingang des Operationsverstärkers rückgekoppelt. So kann die beanspruchte Stromregelung beispielhaft realisiert werden.

Bei einer bevorzugten Ausgestaltung des Feldmessgeräts werden zum aktiven Einstellen eines analogen Stromsignals durch die Mess- und Steuervorrichtung der Stromregler und die Spannungsquelle aktiviert. Durch die Aktivierung von Stromregler und Spannungsquelle ist es grundsätzlich möglich, einen Strom in den Anschlussstrompfad einzuprägen. Das Aktivieren der Spannungsquelle kann in verschiedener Weise realisiert werden. In Analogie zu dem, was zuvor zum Deaktivieren der Spannungsquelle ausgeführt worden ist, kann das Aktivieren der Spannungsquelle beispielsweise bedeuten, dass diese mittels einer Schaltvorrichtung in den Anschlussstrompfad eingeschaltet wird.

Bei einer weiteren bevorzugten Ausgestaltung des Feldmessgeräts ist vorgesehen, dass zum passiven Einstellen eines analogen Stromsignals durch die Mess- und Steuervorrichtung der Stromregler aktiviert wird und die Spannungsquelle deaktiviert wird. Der Strom durch den Anschlussstrompfad wird hier von außen getrieben, also durch ein an den Anschlüssen angeschlossenes externes elektrisches Gerät. Das Feldmessgerät selbst treibt den Strom demnach also nicht aktiv, sondern stellt nur dessen Größe im Anschlussstrompfad ein.

Bei einer bevorzugten Ausgestaltung des Feldmessgeräts ist vorgesehen, dass die Schnittstellenelektronik eine Stromleitvorrichtung aufweist, die zum aktiven Einstellen des analogen oder binären Stromsignals eine Reihenschaltung herstellt von Spannungsquelle, angeschlossenem externen Gerät, Stromregler und Strommessvorrichtung und die zum passiven Einstellen des analogen oder binären Stromsignals eine Reihenschaltung herstellt von angeschlossenem externen Gerät, Stromregler und Strommessvorrichtung. Zur Klarstellung sei nochmals betont, dass ein möglicherweise angeschlossenes externes Gerät hier nicht Bestandteil des Feldmessgerätes ist. Wenn das externe Gerät jedoch angeschlossen ist, stellt sich die beschriebene Konfiguration und die beschriebene Funktionalität ein.

Eine bevorzugte Weiterentwicklung des Feldmessgeräts ist dadurch gekennzeichnet, dass die Stromleitvorrichtung einen Schalter und eine Brückenschaltung umfasst, insbesondere wobei der Schalter elektrisch zwischen dem ersten Anschluss oder dem zweiten Anschluss und einem ersten Anschluss der Brückenschaltung angeordnet ist und wobei der zweite Anschluss oder der erste Anschluss mit einem dem ersten Anschluss der Brückenschaltung gegenüberliegenden zweiten Anschluss der Brückenschaltung elektrisch verbunden ist. Vorzugsweise ist dann ein dritter Anschluss der Brückenschaltung mit der Gerätemasse verbunden (wie andere Schaltungsteile auch) und eindem dtitten Anschluss der Brückenschaltung gegenüberliegender vierter Anschluss der Brückenschaltung mit dem Stromregler oder der Strommessvorrichtung.

Bei einer weiteren Ausgestaltung des Feldmessgeräts ist vorgesehen, dass das binäre Stromsignal erzeugt wird, indem dem Stromregler als mögliche Sollwerte für den Strom im Anschlussstrompfad von der Mess- und Steuervorrichtung nur zwei mögliche Sollwerte vorgegeben werden, nämlich ein Low-Sollwert I_{soll, low} und ein High-Sollwert I_{soll, high}, wobei die beiden Sollwerte die beiden Werte des binären Stromsignals repräsentieren. Wenn der Stromregler ein Spannungssignal als Vorgabewert erwartet, könnten die Spannungen für den Low-Sollwert I_{soll, low} und den High-Sollwert I_{soll, high} von der Mess- und Steuervorrichtung durch einen Digital/Analog-Wandler eingestellt werden, der beispielsweise in einem Mikrocontroller selbst vorgesehen ist oder der als eigenständiger elektronischer Baustein ausgeführt sein kann. Bei dieser Lösung ist zu berücksichtigen, dass aufgrund der benötigten Wandlungszeit bei Einsatz eines D/A-Wandlers mit zeitlichen Einschränkungen beim Wechsel zwischen den binären Werten zu rechnen ist.

Aus dem vorgenannten Grund ist bei einer bevorzugten Weiterentwicklung des Feldmessgeräts vorgesehen, dass der High-Sollwert Iₛₒₗₗ, _{high} für das binäre Stromsignal in der Mess- und Steuervorrichtung als High-Spannungssignal auf einer zuführenden Leitung zum Stromregler erzeugt wird. Ferner ist vorgesehen, dass der Low-Sollwert I_{soll, low} für das binäre Stromsignal in der Mess- und Steuervorrichtung als Low-Spannungssignal erzeugt wird, wobei die zuführende Leitung zum Stromregler vom High-Spannungssignal auf das Low-Spannungssignal gezogen wird durch Schließen eines Halbleiterschalters. Bei dieser Lösung werden die beiden Spannungswerte schaltungstechnisch erzeugt und der Stromregler kann erheblich schneller von dem High-Sollwert auf dem Low-Sollwert und umgekehrt geschaltet werden, als dies bei der angesprochenen Lösung unter Verwendung eines D/A-Wandlers möglich ist. Abgesehen davon, lässt sich so auch ein D/A-Wandler einsparen.

Das Einlesen eines binären Stromsignals wird bei einer bevorzugten Ausgestaltung des Feldmessgeräts dadurch realisiert, dass der von der Strommessvorrichtung in dem Anschlussstrompfad erfasste Istwert Iᵢₛₜ des Stroms im Anschlussstrompfad mittels eines Tiefpassfilters geglättet und insbesondere mittels eines Verstärkers verstärkt wird. Der geglättete und insbesondere verstärkte Istwert Iᵢₛₜ wird dann zur Auswertung einem Komparator zugeleitet und/oder dem analogen Eingang eines Mikrocontrollers der Mess- und Steuervorrichtung. Dadurch ist es möglich, das binäre Stromsignal analog und digital auszuwerten. Der Komparator ist dabei so gewählt, dass er bei einer vorgegebenen Schwelle für den Strom im Anschlussstrompfad schaltet, weshalb er einen digitale Schnittstelle realisiert. Das von dem Komparator gelieferte Ausgangssignal kann dann zur weiteren Auswertung einem digitalen Eingang eines Mikrocontrollers der Mess- und Steuervorrichtung zugeleitet werden.

Im Einzelnen gibt es nun verschiedene Möglichkeiten, das erfindungsgemäße Feldmessgerät auszugestalten und weiterzubilden. Dazu wird verwiesen auf die dem Patentanspruch 1 nachgeordneten Patentansprüche und auf die nachfolgende Beschreibung von Ausführungsbeispielen in Verbindung mit der Zeichnung. In der Zeichnung zeigen:
- Fig. 1: ein Feldmessgerät, wie es aus dem Stand der Technik bekannt ist,
- Fig. 2: die Schnittstellenelektronik eines erfindungsgemäßen Feldmessgeräts,
- Fig. 3: ein Ausführungsbeispiel zur Realisierung des Einlesens eines analogen Stromsignals,
- Fig. 4: ein Ausführungsbeispiel zur Realisierung eines Stromreglers,
- Fig. 5: ein Ausführungsbeispiel zur Realisierung des aktiven Einstellens eines analogen Stromsignals,
- Fig. 6: ein Ausführungsbeispiel zum passiven Einstellen eines analogen Stromsignals,
- Fig. 7: ein Ausführungsbeispiel zum Einstellen eines Stroms mittels eines pulsweitenmodulierten Spannungssignals,
- Fig. 8: ein Ausführungsbeispiel zur Erzeugung eines binären Stromsignals,
- Fig. 9: ein weiteres Ausführungsbeispiel zur Erzeugung eines binären Stromsignals und
- Fig. 10: ein Ausführungsbeispiel zum Einlesen eines binären Stromsignals.

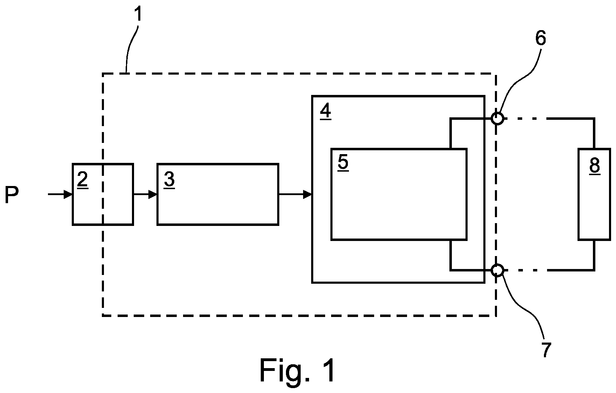

In Fig. 1 ist ein Feldmessgerät 1 dargestellt, wie es aus dem Stand der Technik bekannt ist. Das Feldmessgerät 1 weist einen Sensor 2, einen Messumformer 3 und eine Schnittstellenelektronik 4 auf. Über den Sensor 2 werden in üblicher Weise Informationen über einen technischen Prozess P erfasst, beispielsweise eine Mediumtemperatur oder ein Füllstand. Der Sensor 2 liefert ein Rohmesssignal, das mit dem Messumformer 3 weiterverarbeitet und der Schnittstellenelektronik 4 in geeigneter Form zugänglich gemacht wird. Der Messumformer 3 kann beispielsweise dazu ausgebildet sein, das Rohmesssignal des Sensors 2 extrem hochohmig abzugreifen und es dann zu verstärken und möglicherweise geglättet - allgemein also signalmäßig aufbereitet - der Schnittstellenelektronik 4 zur Verfügung zu stellen. Welche Funktionalität im Einzelnen in dem Messumformer 3 umgesetzt ist, ist hier nicht von Belang.

Die Schnittstellenelektronik 4 weist ihrerseits eine Mess- und Steuervorrichtung 5 und wenigstens einen ersten Anschluss 6 und einen zweiten Anschluss 7 auf. Die Anschlüsse 6, 7 dienen zum Anschließen eines externen elektrischen Geräts 8. Grundsätzlich dienen die Anschlüsse 6, 7 dazu, mit dem externen elektrischen Gerät 8 - beispielsweise einer Leitwarte - Informationen auszutauschen. Dazu können über die Anschlüsse 6, 7 entweder von dem Feldmessgerät 1 Stromsignale ausgegeben oder aber auch empfangen werden. Je nach Ausgestaltung des Feldmessgeräts 1 wird über die Anschlüsse 6, 7 ein analoges Stromsignal ausgegeben oder empfangen oder auch ein binäres Stromsignal ausgegeben oder empfangen. Die verschiedenen Möglichkeiten der Ausgestaltung der Schnittstellenelektronik 4 sind im Stand der Technik häufig alternativ und in Form von verschiedenen sich ausschließenden Hardwarevarianten realisiert.

Die Mess- und Steuervorrichtung 5 kann aus mehreren Komponenten aufgebaut sein, beispielsweise aus einem Mikrocontroller und aus davon verschiedenen elektrischen/elektronischen Organen, mit denen unmittelbar Einfluss auf die elektrische Strecke zwischen dem ersten Anschluss 6 und dem zweiten Anschluss 7 genommen werden kann.

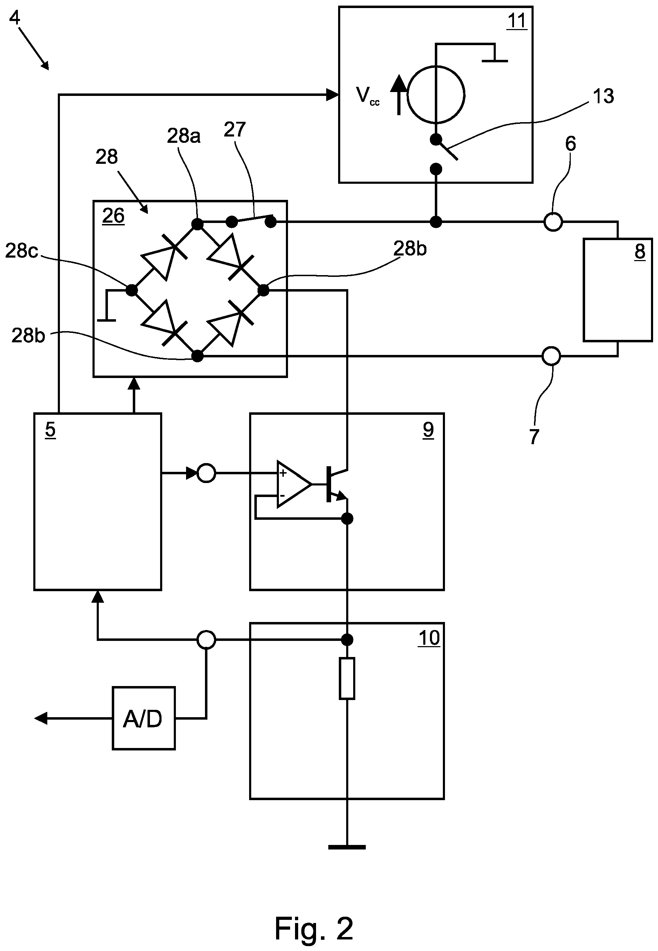

In Fig. 2 ist nur noch die Schnittstellenelektronik 4 dargestellt. Die Schnittstellenelektronik 4 zeichnet sich zunächst dadurch aus, dass zwischen dem ersten Anschluss 6 und dem zweiten Anschluss 7 ein Stromregler 9 und eine Strommessvorrichtung 10 in einem Anschlussstrompfad in Serie geschaltet sind. Dies geschieht in dem dargestellten Ausführungsbeispiel mittelbar über eine Stromleitvorrichtung 26. Die elektrische Verbindung zwischen dem ersten Anschluss 6 über den Stromregler 9 und die Strommessvorrichtung 10 bis hin zum zweiten Anschluss 7 wird also als Anschlussstrompfad bezeichnet.

Ferner weist die Schnittstellenelektronik 4 eine Spannungsquelle 11 auf, wobei die Spannungsquelle 11 in den Anschlussstrompfad einschaltbar und aus dem Anschlussstrompfad heraustrennbar ist, sodass die Spannungsquelle 11 im in den Anschlussstrompfad eingeschalteten Zustand und im Falle eines angeschlossenen externen elektrischen Geräts 8 einen Strom in dem Anschlussstrompfad treiben kann. Die Schnittstellenelektronik 4 ist nun so ausgestaltet, dass die Mess- und Steuervorrichtung 5 den Stromregler 9, die Strommessvorrichtung 10 und die Spannungsquelle 11 so ansteuert und ausliest, dass über den ersten Anschluss 6 und den zweiten Anschluss 7 bei angeschlossenem externen Gerät 8 wahlweise ein analoges Stromsignal oder ein binäres Stromsignal ausgegeben oder eingelesen wird. Die dargestellte Konfiguration erlaubt es also, mit der Schnittstellenelektronik 4 insgesamt vier verschiedene Ein- und Ausgabefunktionalitäten zu realisieren, wobei es bei geeigneter Ansteuerung zudem möglich ist, die Schnittstellenelektronik 4 sowohl passiv als auch aktiv zu betreiben. Dabei bedeutet der passive Betrieb, dass von dem Feldmessgerät 1 bzw. der Schnittstellenelektronik 4 keine eigene Energie zur Verfügung gestellt wird, das Feldmessgerät 1 bzw. die Schnittstellenelektronik 4 also mit einer Energie arbeitet, die von extern - also von dem externen elektrischen Gerät 8 - zur Verfügung gestellt wird. Dagegen bedeutet der aktive Betrieb der Schnittstelle mit dem ersten Anschluss 6 und dem zweiten Anschluss 7, dass das Feldmessgerät 1 bzw. seine Schnittstellenelektronik 4 selbst Energie bereitstellt, um beispielsweise einen Strom über die Anschlüsse 6, 7 nach extern zu treiben; das Bereitstellen der Energie geschieht mit Hilfe der Spannungsquelle 11.

In den nachfolgenden Figuren wird beispielhaft beschrieben, wie nun die verschiedenen Varianten zum Ausgeben oder zum Einlesen eines analogen oder eines binären Stromsignals realisiert werden können.

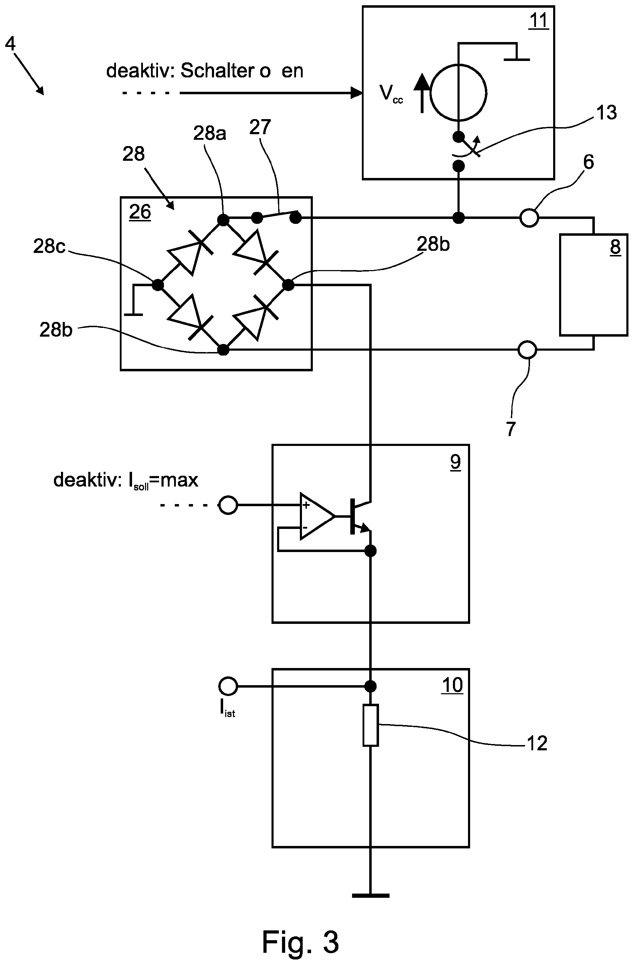

In Fig. 3 ist gezeigt, wie ein insbesondere analoges Stromsignal über den Anschlussstrompfad zwischen dem ersten Anschluss 6 und dem zweiten Anschluss 7, in dem gleichzeitig der Stromregler 9 und die Strommessvorrichtung 10 in Serie geschaltet sind, eingelesen werden kann. Die Strommessvorrichtung 10 erfasst in dem Anschlussstrompfad den Istwert Iᵢₛₜ des Stroms, wobei die Strommessvorrichtung 10 als elektrischer Widerstand 12 ausgebildet ist. Der Spannungsabfall über dem Widerstand 12 kann dann als Maß für den Strom im Anschlussstrompfad von der Mess- und Steuervorrichtung 5 ausgewertet werden. Im vorliegenden Fall ist der elektrische Widerstand 12 ein ohmscher Widerstand, sodass im Wesentlichen ein proportionaler Zusammenhang zwischen dem Strom durch den Widerstand und dem Spannungsabfall über dem Widerstand besteht. Dieser gemessene Istwert Iᵢₛₜ des Stromes im Anschlussstrompfad kann nun als analoger Spannungswert weiterverarbeitet werden oder mittels eines Analog/Digital-Wandlers in einen digital weiterverarbeitbaren Wert gewandelt werden, wie dies in Fig. 2 angedeutet worden ist.

Fig. 3 ist ebenfalls entnehmbar, dass für die Messung eines Stromsignals durch die Mess- und Steuervorrichtung 5 der Stromregler 9 und die Spannungsquelle 11 deaktiviert werden. Dies bedeutet im dargestellten Ausführungsbeispiel, das eine Schaltvorrichtung 13 der Spannungsquelle 11 zum Deaktivieren der Spannungsquelle 11 geöffnet wird (deaktiv: Schalter offen) und dass der Stromregler 9 vollständig aufgesteuert wird, indem ihm als Vorgabewert Iₛₒₗₗ für den Strom im Anschlussstrompfad ein Maximalwert vorgegeben wird (deaktiv: Iₛₒₗₗ = max). Beim Deaktivieren wird die Spannungsquelle 11 also mittels der Schaltvorrichtung 13 aus dem Anschlusstrompfad elektrisch herausgetrennt, sodass über die Spannungsquelle 11 kein Strom mehr in dem Anschlusstrompfad getrieben werden kann.

In Fig. 3 ist ebenfalls dargestellt eine Stromleitvorrichtung 26, die einen Schalter 27 und einen Brückengleichrichter 28 umfasst. In dem hier betrachteten Betriebszustand des Einlesens eines Stromsignals ist der Schalter 27 der Stromleitvorrichtung 26 geschlossen, sodass eine Reihenschaltung von externem Gerät 8, deaktiviertem Stromregler 9 und Strommessvorrichtung 10 realisiert ist.

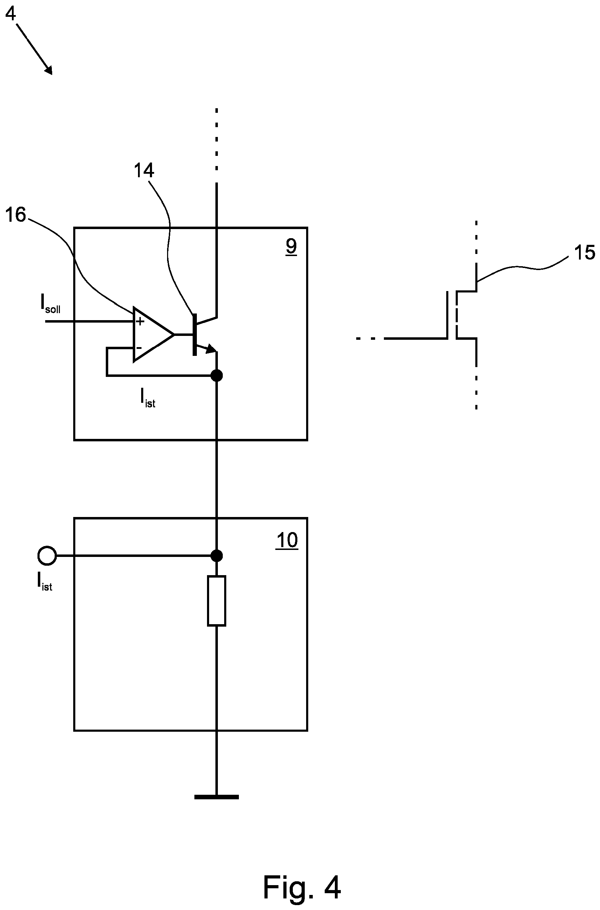

In Fig. 4 ist dargestellt, wie in dem Feldmessgerät 1 in der Schnittstellenelektronik 4 eine Stromregelung realisiert wird, mit der ein gewünschter Wert Iₛₒₗₗ für den Strom im Anschlussstrompfad eingestellt werden kann. Der Stromregler 9 weist im Anschlussstrompfad dazu als Stellglied einen steuerbaren elektrischen Widerstand 14 auf Halbleiterbasis auf. Im vorliegenden Fall ist der steuerbare elektrische Widerstand 14 ein bipolarer Transistor. In einem anderen Ausführungsbeispiel wird anstelle des bipolaren Transistors 14 ein Feldeffekttransistor 15 eingesetzt, wie in Fig. 4 angedeutet. Von der Strommessvorrichtung 10 wird ein Istwert Iᵢₛₜ für den Strom im Anschlussstrompfad erfasst und mit einem vorgegebenen Sollwert Iₛₒₗₗ für den Strom im Anschlusspfad verglichen. Der steuerbare elektrische Widerstand 14 wird dann so angesteuert, dass die Regeldifferenz aus Sollwert Iₛₒₗₗ und Istwert IiSt für den Strom im Anschlussstrompfad verkleinert wird, vorzugsweise zu null geregelt wird. Im vorliegenden Fall wird die Regeldifferenz mithilfe eines Operationsverstärkers 16 gebildet, der dann die Steuerelektrode des Transistors 14 ansteuert und so den Widerstand über die Kollektor-Emitter-Strecke variiert, bis die Regeldifferenz sich zu null einstellt.

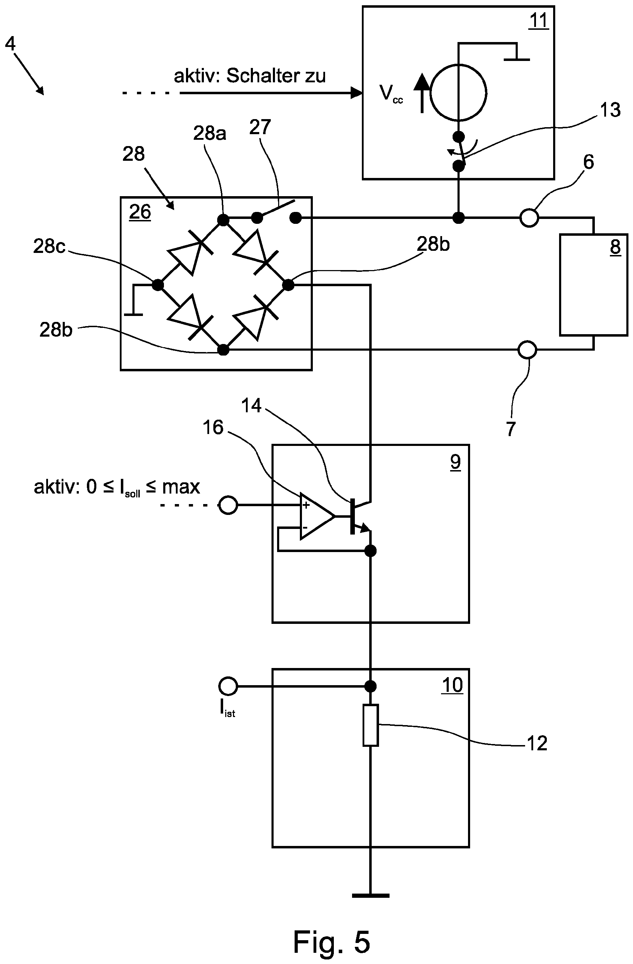

In Fig. 5 ist zusätzlich dargestellt, dass zum aktiven Einstellen eines - analogen - Stromsignals durch die Mess- und Steuervorrichtung 5 der Stromregler 9 und die Spannungsquelle 11 aktiviert werden. Im dargestellten Beispiel bedeutet dies, dass der Schalter 13 in der Spannungsquelle 11 geschlossen wird (aktiv: Schalter zu) und dass der Stromregler 9 in seinem Stellbereich angesteuert wird (aktiv: 0 ≤ Iₛₒₗₗ ≤ max), sodass der steuerbare elektrische Widerstand 14 nicht in einen Sättigungsbereich gerät. Dadurch, dass der Schalter 13 der Spannungsquelle 11 geschlossen ist, kann die Spannungsquelle 11 einen Strom in dem Anschlussstrompfad treiben.

Die Stromleitvorrichtung 26 der Schnittstellenelektronik 4 stellt zum aktiven Einstellen des analogen oder binären Stromsignals eine Reihenschaltung her von Spannungsquelle 11, angeschlossenem externen Gerät 8, Stromregler 9 und Strommessvorrichtung 10. Von der Spannungsquelle 11 aus betrachtet wird ein Strom getrieben über den ersten Anschluss 6, das externe Gerät 8, den zweiten Anschluss 7, den zweiten Anschluss 28b des Brückengleichrichters 28, den vierten Anschluss 28d des Brückengleichrichters 28, den Stromregler 9 und die Strommessvorrichtung 10, wobei der Stromkreis dann über die Gerätemasse geschlossen ist.

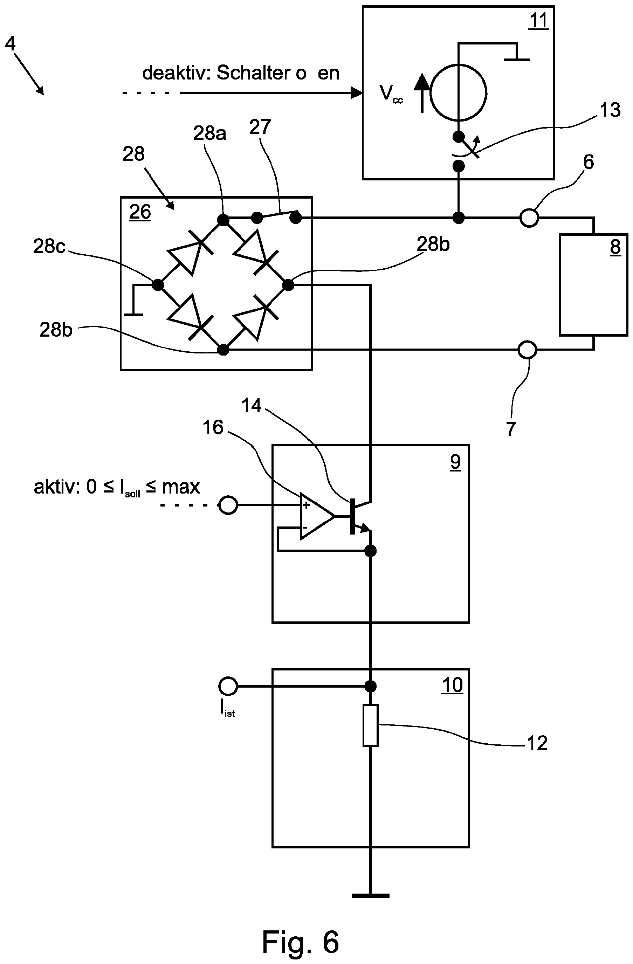

Demgegenüber ist in Fig. 6 dargestellt, dass zum passiven Einstellen eines analogen Stromsignals in dem Anschlussstrompfad durch die Mess- und Steuervorrichtung 5 der Stromregler 9 aktiviert wird und die Spannungsquelle 11 deaktiviert wird. Zum Deaktivieren der Spannungsquelle 11 wird wiederum der Schalter 13 geöffnet. In diesem Fall kann die Spannungsquelle 11 also keinen Strom in den Anschlussstrompfad einspeisen, sodass der Strom in dem Anschlussstrompfad alleine von einer externen Energiequelle, die sich beispielsweise in dem angeschlossenen externen elektrischen Gerät 8 befindet, getrieben wird.

An dieser Stelle bietet sich ein Vergleich zur Wirkweise der Stromleitvorrichtung 26 in dem Fall an, dass ein Strom passiv - also von extern - in dem Feldmessgerät 1 getrieben wird, wobei die Höhe des Stroms im Feldmessgerät 1 eingestellt wird. Zum passiven Einstellen des analogen oder binären Stromsignals stellt die Stromleitvorrichtung 26 eine Reihenschaltung her von angeschlossenem externen Gerät 8, Stromregler 9 und Strommessvorrichtung 10. In diesem Fall weist das externe Gerät 8 eine Spannungsquelle auf, die hier nicht ausdrücklich dargestellt ist. Von dem externen Gerät 8 aus betrachtet wird ein Strom getrieben über den ersten Anschluss 6, den Schalter 27 der Stromleitvorrichtung 26, den ersten Anschluss 28a des Brückengleichrichters 28, den vierten Anschluss 28d des Brückengleichrichters 28, den Stromregler 9 und die Strommessvorrichtung 10, über die Gerätemasse zum dritten Anschluss 28c des Brückengleichrichters 28, den zweiten Anschluss 28b des Brückengleichrichters 28 und schließlich den zweiten Anschluss 7 der Schnittstellenelektronik 4, an dem das externe Gerät 8 angeschlossen ist. Dieser Betrachtung liegt die Vorstellung zugrunde, dass das hohe Potenzial der Spannungsquelle des externen Geräts 8 an dem ersten Anschluss 6 anliegt.

Dank der Stromleiteinrichtung 26 mit dem Brückengleichrichter 28 wird automatisch ein Verpolschutz realisiert, sodass das externe Gerät 8 auch mit genau anderer Polarität seiner angenommenen Spannungsquelle an den ersten Anschluss 6 und den zweiten Anschluss 7 angeschlossen werden könnte, ohne dass sich an der Funktionalität des Feldmessgerätes - von außen betrachtet - etwas änderte. Intern ändert sich dann natürlich der Strompfad durch den Brückengleichrichter 28.

Aus der Erläuterung ergibt sich, dass Schalter 27 geöffnet wird, wenn Schaltvorrichtung 13 geschlossen wird und vice versa.

Allen gezeigten Stromleitvorrichtungen 26 ist gemeinsam, dass sie einen Schalter 27 und einen Brückengleichrichter 28 umfassen, wobei der Schalter 27 elektrisch zwischen dem ersten Anschluss 6 (oder dem zweiten Anschluss 7) und einem ersten Anschluss 28a des Brückengleichrichters 28 angeordnet ist und wobei der zweite Anschluss 7 (oder der erste Anschluss 6) mit einem dem ersten Anschluss 28a des Brückengleichrichters 28 gegenüberliegenden zweiten Anschluss 28b des Brückengleichrichters 28 elektrisch verbunden ist. Ein dritter Anschluss 28c des Brückengleichrichters 28 ist mit der elektrischen Gerätemasse verbunden und ein vierter Anschluss 28d des Brückengleichrichters 28 ist schließlich mit dem Stromregler 9 oder der Strommessvorrichtung 10 verbunden.

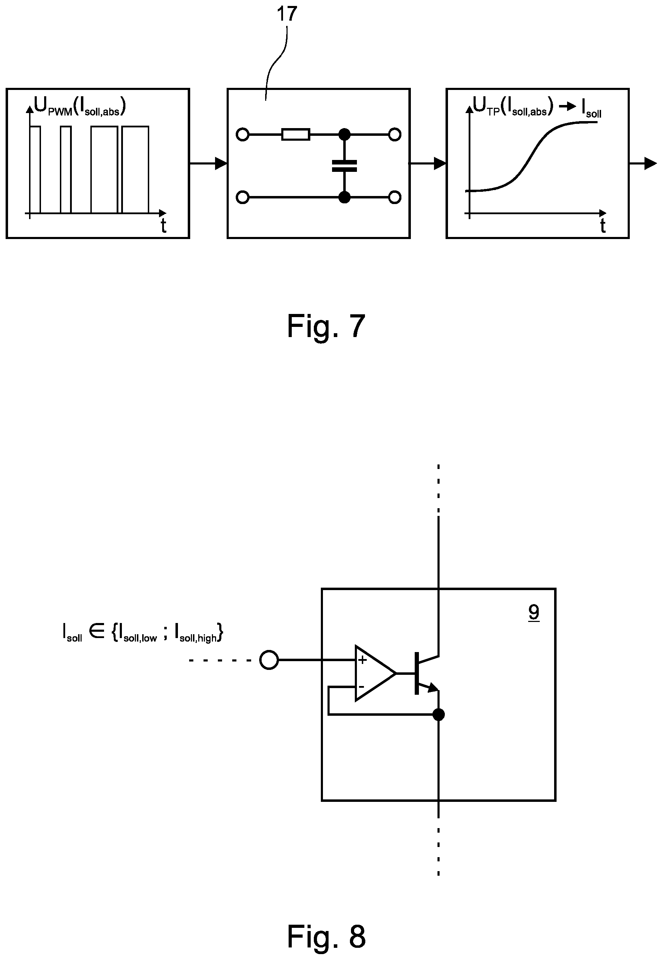

In Fig. 7 ist dargestellt, wie der Sollwert Iₛₒₗₗ für den Strom im Anschlussstrompfad vorteilhaft generiert werden kann, ohne auf einen Digital/AnalogWandler zurückgreifen zu müssen. Die hier dargestellte Lösung unter Verwendung eines pulsweitenmodulierten Signals U_{PWM} ist in der Ausführung auch kostengünstiger realisierbar als durch Verwendung eines zusätzlichen Digital/Analog-Wandlers als externem Bauteil oder unter Blockade eines Digital/Analog-Wandlers eines Mikrocontrollers, der üblicherweise Bestandteil der Mess- und Steuervorrichtung 5 ist. In Fig. 7 ist jedenfalls gezeigt, dass der Sollwert Iₛₒₗₗ für den Strom im Anschlusstrompfad von der Mess- und Steuervorrichtung 5 als eine Sollspannung erzeugt wird, indem ein vorgegebener abstrakter Sollwert I_{soll, abs} für den Strom zunächst in ein pulsweitenmoduliertes Spannungssignal U_{PWM} (I_{soll, abs}) umgesetzt wird. Das pulsweitenmodulierte Spannungssignal U_{PWM} wird dann mittels eines Tiefpasses 17 geglättet und das geglättete Spannungssignal U_{TP} wird dann mittelbar oder unmittelbar als Sollspannung für den Stromregler 9 verwendet, wobei diese Sollspannung den Sollwert Iₛₒₗₗ für den Strom darstellt.

Fig. 8 zeigt ein Detail zur Erzeugung eines binären Stromsignals. In dem dargestellten Fall wird ein binäres Stromsignal erzeugt, indem dem Stromregler 9 als mögliche Sollwerte Iₛₒₗₗ für den Strom im Anschlusspfad von der Mess- und Steuervorrichtung 5 nur zwei mögliche Sollwerte Iₛₒₗₗ vorgegeben werden, nämlich ein Low-Sollwert Iₛₒₗₗ, _{low} und ein High-Sollwert I_{soll, high}, wobei die beiden Sollwerte die beiden Werte des binären Stromsignals repräsentieren.

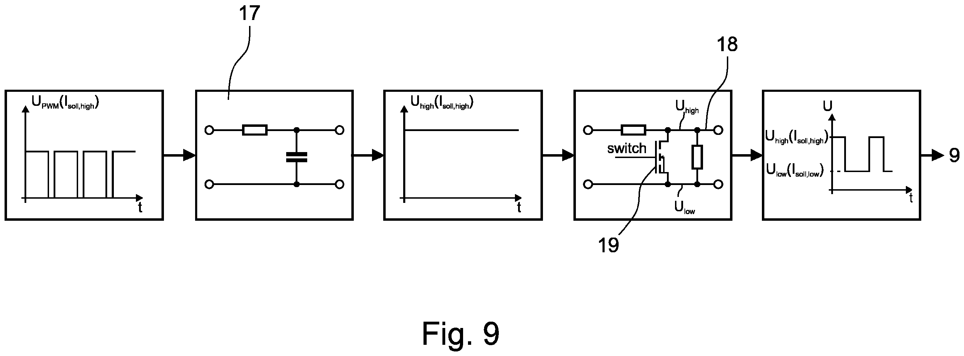

In Fig. 9 ist nun dargestellt, wie auf sehr effektive Art und Weise zwei Spannungen erzeugt werden können, nämlich eine Spannung, die dem High-Sollwert Iₛₒₗₗ, _{high} entspricht, und eine andere Spannung, die dem Low-Sollwert Iₛₒₗₗ, _{low} für den Strom im Anschlussstrompfad entspricht. Für die hier dargestellte Realisierung wird beispielsweise kein Digital/Analog-Wandler benötigt, die beiden binären Vorgabespannungen U_{high} und U_{low} für den Stromregler 9 werden vorliegend schaltungstechnisch erzeugt, wobei durch Schließen eines einfachen Schalters 19 zwischen den beiden Spannungen U_{high} und U_{low} praktisch ohne Zeitverzögerung hin- und hergeschaltet werden kann. Im Ergebnis wird der High-Sollwert Iₛₒₗₗ, _{high} für das binäre Stromsignal in der Mess- und Steuervorrichtung 5 als High-Spannungssignal U_{high} auf einer zuführenden Leitung 18 zum Stromregler 9 hin erzeugt. Ferner wird auch der Low-Sollwert I_{soll, low} für das binäre Stromsignal in der Mess- und Steuervorrichtung 5 als Low-Spannungssignal U_{low} erzeugt. Die zuführende Leitung 18 zum Stromregler 9 wird vom High-Spannungssignal U_{high} auf das Low-Spannungssignal U_{low} durch das Schließen eines Halbleiterschalters 19 gezogen. In dem zweiten Kästchen von rechts in Fig. 9 ist zu erkennen, dass die Spannung U_{high} noch zusätzlich durch einen Spannungsteiler mit zwei ohmschen Widerständen eingestellt wird. Zur Signalanpassung kann diese Maßnahme ergriffen werden, es ist jedoch nicht unbedingt erforderlich. Die Verwendung eines Spannungsteilers ist aber in folgender Situation geboten: Damit das Umschalten zwischen zwei Strömen mit hoher Geschwindigkeit stattfinden kann, muss der vorgelagerte Tiefpass 17 einen möglichst geringen Ausgangswiderstand haben. Somit wird ein aktiver Tiefpass (unter Verwendung von Operationsverstärkern) verwendet. Wird dann auf einen Spannungsteiler verzichtet, würde der Ausgang des Operationsverstärkers kurzgeschlossen, was natürlich zu vermeiden ist; in dieser Situation ist also ein Spannungsteiler zwingend erforderlich. Wenn ein solcher Spannungsteiler realisiert wird, dann ist das High-Spannungssignal U_{high} auf der Eingangsseite nicht identisch mit dem High-Spannungssignal U_{high} auf der Ausgangsseite des Spannungsteilers, also auf der zuführenden Leitung 18 zum Stromregler 9. Das ausgangsseitige High-Spannungssignal könnte dann auch als U'_{high} geschrieben werden. Für den Fachmann ist ohne Weiteres verständlich, was gemeint ist.

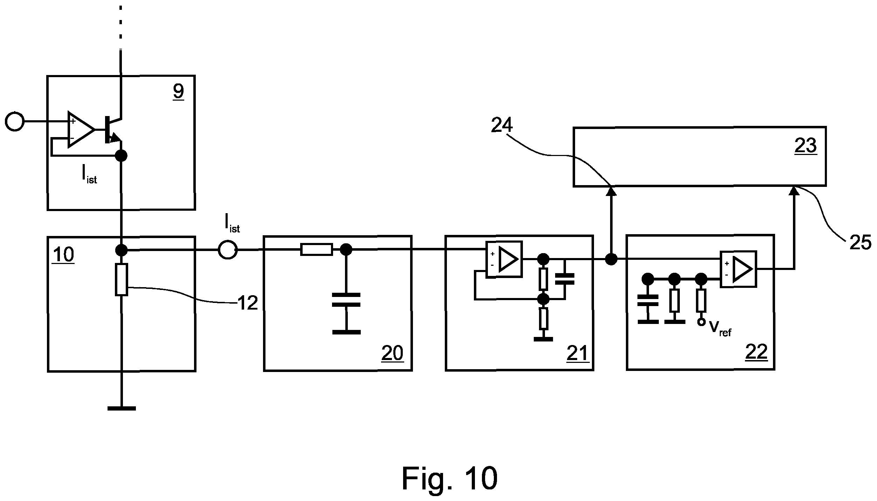

In Fig. 10 ist anhand eines Ausführungsbeispiels dargestellt, wie ein binäres Stromsignal eingelesen wird. Von der Strommessvorrichtung 10 wird zunächst der in dem Anschlussstrompfad erfasste Istwert Iᵢₛₜ des Stroms erfasst. Dieses Signal wird mittels eines Tiefpassfilters 20 geglättet und mithilfe eines Verstärkers 21 verstärkt, sofern dies erforderlich ist. Der geglättete und insbesondere verstärkte Istwert Iᵢₛₜ kann dann einer weiteren Auswertung zugeleitet werden. In Fig. 10 wird er zum einen direkt dem analogen Eingang 24 eines Mikrocontrollers 23 der Mess- und Steuervorrichtung 5 zugeleitet. Gleichzeitig wird er aber auch zur Auswertung einem Komparator 22 zugeleitet, der in Abhängigkeit von einer Vergleichsspannung ein binäres Ausgangssignal ausgibt und dieses dem digitalen Eingang 25 des Mikrocontrollers 23 zuführt. Es ist selbstverständlich, dass die beiden Arten der Auswertung nicht gleichzeitig realisiert werden müssen, sie können jedoch gleichzeitig realisiert werden.

### Bezugszeichen

- 1: Feldmessgerät
- 2: Sensor
- 3: Messumformer
- 4: Schnittstellenelektronik
- 5: Steuervorrichtung
- 6: erster Anschluss
- 7: zweiter Anschluss
- 8: externes Gerät
- 9: Stromregler
- 10: Strommessvorrichtung
- 11: Spannungsquelle
- 12: elektrischer Widerstand
- 13: Schaltvorrichtung
- 14: steuerbarer elektrischer Widerstand
- 15: Feldeffekttransistor
- 16: Operationsverstärker
- 17: Tiefpass
- 18: zuführende Leitung
- 19: Halbleiterschalter
- 20: Tiefpassfilter
- 21: Verstärker
- 22: Komparator
- 23: Mikrocontroller
- 24: analoger Eingang
- 25: digitaler Eingang
- 26: Stromleitvorrichtung
- 27: Schalter
- 28: Brückengleichrichter (28a ... 28d = erster Anschluss ... vierter Anschluss)

## Patentansprüche

1. Feldmessgerät (1) mit einem Sensor (2), mit einem Messumformer (3) und mit einer Schnittstellenelektronik (4), wobei die Schnittstellenelektronik (4) eine Mess- und Steuervorrichtung (5) und wenigstens einen ersten Anschluss (6) und einen zweiten Anschluss (7) zum Anschließen eines externen elektrischen Geräts (8) aufweist,
**dadurch gekennzeichnet,**
**dass** bei der Schnittstellenelektronik (4) in einem Anschlussstrompfad zwischen dem ersten Anschluss (6) und dem zweiten Anschluss (7) ein Stromregler (9) und eine Strommessvorrichtung (10) in Serie geschaltet sind, dass die Schnittstellenelektronik (4) eine Spannungsquelle (11) aufweist und die Spannungsquelle (11) in den Anschlussstrompfad einschaltbar und aus dem Anschlussstrompfad heraustrennbar ist, sodass die Spannungsquelle (11) im in den Anschlussstrompfad eingeschalteten Zustand und im Falle eines angeschlossenen externen elektrischen Geräts (8) einen Strom in dem Anschlussstrompfad treiben kann,
**dass** die Mess- und Steuervorrichtung (5) den Stromregler (9), die Strommessvorrichtung (10) und die Spannungsquelle (11) so ansteuert und ausliest, dass über den ersten Anschluss (6) und den zweiten Anschluss (7) bei angeschlossenem externen Gerät (8) wahlweise ein analoges Stromsignal oder ein binäres Stromsignal ausgegeben oder eingelesen wird.

2. Feldmessgerät (1) nach Anspruch 1, **dadurch gekennzeichnet, dass** die Strommessvorrichtung (10) in dem Anschlussstrompfad als elektrischer Widerstand (12) ausgebildet ist, insbesondere als ohmscher Widerstand, und der Spannungsabfall über dem elektrischen Widerstand (12) als Maß für den Strom im Anschlusstrompfad von der Mess- und Steuervorrichtung (5) ausgewertet wird, insbesondere wobei der Spannungsabfall durch einen Analog/Digital-Wandler in einen entsprechenden digitalen Datenwert gewandelt und digital weiterverarbeitet wird.

3. Feldmessgerät (1) nach Anspruch 2, **dadurch gekennzeichnet, dass** für die Messung eines analogen Stromsignals durch die Mess- und Steuervorrichtung (5) der Stromregler (9) und die Spannungsquelle (11) deaktiviert werden.

4. Feldmessgerät (1) nach einem der Ansprüche 1 bis 3, **dadurch gekennzeichnet, dass** der Stromregler (9) als Stellglied einen steuerbaren elektrischen Widerstand (14), insbesondere auf Halbleiterbasis, im Anschlussstrompfad aufweist, wobei, insbesondere von der Strommessvorrichtung (10), ein Istwert Iᵢₛₜ für den Strom im Anschlussstrompfad erfasst wird und mit einem vorgegebenen Sollwert Iₛₒₗₗ für den Strom im Anschlussstrompfad verglichen wird, und der steuerbare elektrische Widerstand (14) so angesteuert wird, dass die Regeldifferenz aus Sollwert Iₛₒₗₗ und Istwert Iᵢₛₜ für den Strom im Anschlussstrompfad verkleinert wird, insbesondere zu null geregelt wird.

5. Feldmessgerät (1) nach einem der Ansprüche 1 bis 4, **dadurch gekennzeichnet, dass** zum aktiven Einstellen des analogen oder binären Stromsignals durch die Mess- und Steuervorrichtung (5) der Stromregler (9) und die Spannungsquelle (11) aktiviert werden.

6. Feldmessgerät (1) nach einem der Ansprüche 1 bis 5, **dadurch gekennzeichnet, dass** zum passiven Einstellen des analogen oder binären Stromsignals durch die Mess- und Steuervorrichtung (5) der Stromregler (9) aktiviert wird und die Spannungsquelle (11) deaktiviert wird.

7. Feldmessgerät (1) nach einem der Ansprüche 1 bis 6, **dadurch gekennzeichnet, dass** der Stromregler (9) durch die Mess- und Steuervorrichtung (5) deaktiviert wird, indem er voll aufgesteuert wird oder in dem Anschlussstrompfad überbrückt wird.

8. Feldmessgerät (1) nach einem der Ansprüche 1 bis 7, **dadurch gekennzeichnet, dass** die Spannungsquelle (11) durch die Mess- und Steuervorrichtung (5) deaktiviert wird, indem sie mittels einer Schaltvorrichtung (13) aus dem Anschlusstrompfad elektrisch herausgetrennt wird, sodass über die Spannungsquelle (11) kein Strom mehr in dem Anschlusstrompfad getrieben wird.

9. Feldmessgerät (1) nach einem der Ansprüche 5 bis 8, **dadurch gekennzeichnet, dass** die Schnittstellenelektronik (4) eine Stromleitvorrichtung (26) aufweist, die zum aktiven Einstellen des analogen oder binären Stromsignals eine Reihenschaltung herstellt von Spannungsquelle (11), angeschlossenem externen Gerät (8), Stromregler (9) und Strommessvorrichtung (10), und die zum passiven Einstellen des analogen oder binären Stromsignals eine Reihenschaltung herstellt von angeschlossenem externen Gerät (8), Stromregler (9) und Strommessvorrichtung (10)

10. Feldmessgerät nach Anspruch 9, **dadurch gekennzeichnet, dass** die Stromleitvorrichtung (26) einen Schalter (27) und einen Brückengleichrichter (28) umfasst, insbesondere wobei der Schalter (27) elektrisch zwischen dem ersten Anschluss (6) oder dem zweiten Anschluss (7) und einem ersten Anschluss (28a) des Brückengleichrichters (28) angeordnet ist und wobei der zweite Anschluss (7) oder der erste Anschluss (6) mit einem dem ersten Anschluss (28a) des Brückengleichrichters (28) gegenüberliegenden zweiten Anschluss (28b) des Brückengleichrichters (28) elektrisch verbunden ist.

11. Feldmessgerät (1) nach einem der Ansprüche 4 bis 10, **dadurch gekennzeichnet, dass** der Sollwert Iₛₒₗₗ für den Strom im Anschlussstrompfad von der Mess- und Steuervorrichtung (5) als eine Sollspannung erzeugt wird, indem ein vorgegebener abstrakter Sollwert Iₛₒₗₗ, _{abs} für den Strom in ein pulsweitenmoduliertes Spannungssignal U_{PWM} umgesetzt wird, das pulsweitenmodulierte Spannungssignal U_{PWM} mittels eines Tiefpasses (17) geglättet wird und das geglättete Spannungssignal U_{TP} mittelbar oder unmittelbar als Sollspannung verwendet wird, die den Sollwert Iₛₒₗₗ für den Strom darstellt.

12. Feldmessgerät (1) nach einem der Ansprüche 1 bis 11, **dadurch gekennzeichnet, dass** das binäre Stromsignal erzeugt wird, indem dem Stromregler (9) als mögliche Sollwerte Iₛₒₗₗ für den Strom im Anschlussstrompfad von der Mess- und Steuervorrichtung (5) nur zwei mögliche Sollwerte vorgegeben werden, nämlich ein Low-Sollwert I_{soll, low} und ein High-Sollwert Iₛₒₗₗ, _{high}, wobei die beiden Sollwerte die beiden Werte des binären Stromsignals repräsentieren.

13. Feldmessgerät (1) nach Anspruch 12, **dadurch gekennzeichnet, dass** der High-Sollwert I_{soll, high} für das binäre Stromsignal in der Mess- und Steuervorrichtung (5) als High-Spannungssignal U_{high}(I_{soll, high}) auf einer zuführenden Leitung (18) zum Stromregler (9) erzeugt wird, dass der Low-Sollwert I_{soll, low} für das binäre Stromsignal in der Mess- und Steuervorrichtung (5) als Low-Spannungssignal U_{low}(I_{soll, low}) erzeugt wird, und dass die zuführende Leitung (18) zum Stromregler (9) vom High-Spannungssignal U_{high} auf das Low-Spannungssignal U_{low} gezogen wird durch Schließen eines Halbleiterschalters (19).

14. Feldmessgerät (1) nach einem der Ansprüche 1 bis 13, **dadurch gekennzeichnet, dass** das binäre Stromsignal eingelesen wird, indem der von der Strommessvorrichtung (10) in dem Anschlussstrompfad erfasste Istwert Iᵢₛₜ des Stroms im Anschlussstrompfad mittels eines Tiefpassfilters (20) geglättet und insbesondere mittels eines Verstärkers (21) verstärkt wird und der geglättete und insbesondere verstärkte Istwert Iᵢₛₜ zur Auswertung einem Komparator (22) zugeleitet wird und/oder dem analogen Eingang (24) eines Mikrocontrollers (23) der Mess- und Steuervorrichtung (5).

15. Feldmessgerät (1) nach Anspruch 14, **dadurch gekennzeichnet, dass** das von dem Komparator (22) gelieferte Ausgangssignal zur weiteren Auswertung dem digitalen Eingang (25) des Mikrocontrollers (23) der Mess- und Steuervorrichtung (5) zugeleitet wird.

## Claims

1. Field measuring device (1) having a sensor (2), having a measuring transducer (3) and having interface electronics (4), wherein the interface electronics (4) have a measuring and control device (5) and at least one first terminal (6) and one second terminal (7) for connecting an external electrical device (8),
**characterized in**
**that** a current controller (9) and a current measuring device (10) are connected in series in a terminal current path between the first terminal (6) and the second terminal (7) in the interface electronics (4),
**that** the interface electronics (4) has a voltage source (11) and the voltage source (11) can be switched on in the terminal current path and disconnected from the terminal current path, so that the voltage source (11) can drive a current in the terminal current path in the switched-on state in the terminal current path and in the case of a connected external electrical device (8),
**that** the measuring and control device (5) actuates and reads the current controller (9), the current measuring device (10) and the voltage source (11) in such a way that optionally an analog current signal or a binary current signal is output or input via the first terminal (6) and the second terminal (7) when an external device (8) is connected.

2. Field measuring device (1) according to claim 1, **characterized in that** the current measuring device (10) in the terminal current path is implemented as an electrical resistor (12), in particular as an ohmic resistor, and the voltage drop across the electrical resistor (12) is evaluated by the measuring and control device (5) as a measure for the current in the terminal current path, in particular wherein the voltage drop is converted by an analog-to-digital converter into a corresponding digital data value and further processed digitally.

3. Field measuring device (1) according to claim 2, **characterized in that** the current controller (9) and the voltage source (11) are deactivated for the measurement of an analog current signal by the measuring and control device (5).

4. Field measuring device (1) according to any one of claims 1 to 3, **characterized in that** the current controller (9) has, as an actuator, a controllable electrical resistor (14), in particular based on semiconductors, in the terminal current path, wherein, in particular from the current measuring device (10), an actual value Iᵢₛₜ for the current in the terminal current path is registered and compared with a predetermined setpoint value Iₛₒₗₗ for the current in the terminal current path, and the controllable electrical resistor (14) is actuated in such a way that the control difference between the setpoint value Iₛₒₗₗ and the actual value Iᵢₛₜ for the current in the terminal current path is reduced, in particular is regulated to zero.

5. Field measuring device (1) according to any one of claims 1 to 4, **characterized in that** for the active setting of the analog or binary current signal, the current controller (9) and the voltage source (11) are activated by the measuring and control device (5).

6. Field measuring device (1) according to any one of claims 1 to 5, **characterized in that**, for passive setting of the analog or binary current signal, the current controller (9) is activated and the voltage source (11) is deactivated by the measuring and control device (5).

7. Field measuring device (1) according to any one of claims 1 to 6, **characterized in that** the current controller (9) is deactivated by the measuring and control device (5) by being set at maximum or by being bypassed in the terminal current path.

8. Field measuring device (1) according to any one of claims 1 to 7, **characterized in that** the voltage source (11) is deactivated by the measuring and control device (5) by being electrically disconnected from the terminal current path by means of a switching device (13), so that no current is driven in the terminal current path by the voltage source (11).

9. Field measuring device (1) according to any one of claims 5 to 8, **characterized in that** the interface electronics (4) has a current conducting device (26) which, for the active setting of the analog or binary current signal, implements a series connection of the voltage source (11), the connected external device (8), the current controller (9) and the current measuring device (10), and which, for the passive setting of the analog or binary current signal, implements a series connection of the connected external device (8), the current controller (9) and the current measuring device (10).

10. Field measuring device according to claim 9, **characterized in that** the current conducting device (26) comprises a switch (27) and a bridge rectifier (28), in particular wherein the switch (27) is electrically arranged between the first terminal (6) or the second terminal (7) and a first terminal (28a) of the bridge rectifier (28) and wherein the second terminal (7) or the first terminal (6) is electrically connected to a second terminal (28b) of the bridge rectifier (28) opposite the first terminal (28a) of the bridge rectifier (28).

11. Field measuring device (1) according to any one of claims 4 to 10, **characterized in that** the setpoint value Iₛₒₗₗ for the current in the terminal current path is generated by the measuring and control device (5) as a setpoint voltage **in that** a predetermined abstract setpoint value I_{soll, abs} for the current is converted into a pulse-width-modulated voltage signal U_{PWM}, the pulse-width-modulated voltage signal U_{PWM} is smoothed by means of a low-pass filter (17) and the smoothed voltage signal U_{TP} is used indirectly or directly as setpoint voltage which represents the setpoint value Iₛₒₗₗ for the current.

12. Field measuring device (1) according to any one of claims 1 to 11, **characterized in that** the binary current signal is generated by the measuring and control device (5) **in that** only two possible setpoint values, namely a low setpoint value I_{soll, low} and a high setpoint value I_{soll, high}, are provided to the current controller (9) as possible setpoint values Iₛₒₗₗ for the current in the terminal current path, wherein the two setpoint values represent the two values of the binary current signal.

13. Field measuring device (1) according to claim 12, **characterized in that** the high setpoint value I_{soll, high} for the binary current signal in the measuring and control device (5) is generated as a high voltage signal U_{high}(I_{soll, high}) on a supply line (18) to the current controller (9), that the low setpoint value I_{soll, low} for the binary current signal in the measuring and control device (5) is generated as a low-voltage signal U_{low} (I_{soll, low}), and **in that** the supply line (18) to the current controller (9) is drawn from the high-voltage signal U_{high} to the low-voltage signal U_{low} by closing a semiconductor switch (19).

14. Field measuring device (1) according to any one of claims 1 to 13, **characterized in that** the binary current signal is input, **in that** the actual value Iᵢₛₜ of the current in the terminal current path registered by the current measuring device (10) in the terminal current path is smoothed by means of a low-pass filter (20) and in particular amplified by means of an amplifier (21) and the smoothed and in particular amplified actual value Iᵢₛₜ is supplied to a comparator (22) and/or to the analog input (24) of a microcontroller (23) of the measuring and control device (5) for evaluation.

15. Field measuring device (1) according to claim 14, **characterized in that** the output signal supplied by the comparator (22) is supplied to the digital input (25) of the microcontroller (23) of the measuring and control device (5) for further evaluation.

## Revendications

1. Appareil de mesure de terrain (1), comprenant un capteur (2), un transducteur de mesure (3) et une électronique d'interface (4), l'électronique d'interface (4) présentant un dispositif de mesure et de commande (5) et au moins un premier port (6) et un deuxième port (7) pour connecter un appareil électrique externe (8),
**caractérisé**
**en ce que** pour l'électronique d'interface (4), un régulateur de courant (9) et un dispositif de mesure de courant (10) sont connectés en série sur un trajet de courant de connexion entre le premier port (6) et le deuxième port (7),
**en ce que** l'électronique d'interface (4) présente une source de tension (11) et la source de tension (11) peut être mise en circuit sur le trajet de courant de connexion et peut être mise hors circuit du trajet de courant de connexion de sorte que la source de tension (11), à l'état en circuit sur le trajet de courant de connexion et avec un appareil électrique externe connecté (8), peut injecter un courant sur le trajet de courant de connexion,
**en ce que** le dispositif de mesure et de commande (5) pilote et lit le régulateur de courant (9), le dispositif de mesure de courant (10) et la source de tension (11) de telle sorte qu'avec un appareil externe connecté (8), au choix un signal de courant analogique ou un signal de courant binaire est délivré ou lu par le premier port (6) et le deuxième port (7).

2. Appareil de mesure de terrain (1) selon la revendication 1, **caractérisé en ce que** le dispositif de mesure de courant (10) est réalisé sur le trajet de courant de connexion sous forme de résistance électrique (12), en particulier de résistance ohmique, et la chute de tension aux bornes de la résistance électrique (12) est évaluée par le dispositif de mesure et de commande (5) comme une mesure du courant sur le trajet de courant de connexion, en particulier dans lequel la chute de tension est convertie par un convertisseur analogique/numérique en une valeur de données numérique correspondante et subit un traitement ultérieur numérique.

3. Appareil de mesure de terrain (1) selon la revendication 2, **caractérisé en ce que** le régulateur de courant (9) et la source de tension (11) sont désactivés pour la mesure d'un signal de courant analogique par le dispositif de mesure et de commande (5) .

4. Appareil de mesure de terrain (1) selon l'une quelconque des revendications 1 à 3, **caractérisé en ce que** le régulateur de courant (9) présente en tant qu'actionneur une résistance électrique réglable (14), en particulier à base de semi-conducteurs, sur le trajet de courant de connexion, dans lequel une valeur réelle Iᵢₛₜ est détectée, en particulier par le dispositif de mesure de courant (10), pour le courant sur le trajet de courant de connexion et est comparée à une valeur théorique prédéfinie Iₛₒₗₗ pour le courant sur le trajet de courant de connexion, et la résistance électrique réglable (14) est pilotée de telle sorte que la différence de régulation entre la valeur théorique Iₛₒₗₗ et la valeur réelle Iᵢₛₜ pour le courant sur le trajet de courant de connexion est diminuée, en portée vers zéro.

5. Appareil de mesure de terrain (1) selon l'une quelconque des revendications 1 à 4, **caractérisé en ce que** le régulateur de courant (9) et la source de tension (11) sont activés pour un réglage actif du signal de courant analogique ou binaire par le dispositif de mesure et de commande (5).

6. Appareil de mesure de terrain (1) selon l'une quelconque des revendications 1 à 5, **caractérisé en ce que** le régulateur de courant (9) est activé et la source de tension (11) est désactivée pour un réglage passif du signal de courant analogique ou binaire par le dispositif de mesure et de commande (5).

7. Appareil de mesure de terrain (1) selon l'une quelconque des revendications 1 à 6, **caractérisé en ce que** le régulateur de courant (9) est désactivé par le dispositif de mesure et de commande (5) en étant complètement ouvert ou court-circuité sur le trajet de courant de connexion.

8. Appareil de mesure de terrain (1) selon l'une quelconque des revendications 1 à 7, **caractérisé en ce que** la source de tension (11) est désactivée par le dispositif de mesure et de commande (5) en étant électriquement séparée du trajet de courant de connexion au moyen d'un dispositif de commutation (13) de sorte qu'aucun courant n'est plus injecté sur le trajet de courant de connexion par la source de tension (11).

9. Appareil de mesure de terrain (1) selon l'une quelconque des revendications 5 à 8, **caractérisé en ce que** l'électronique d'interface (4) présente un dispositif conducteur de courant (26) qui établit une connexion en série pour le réglage actif du signal de courant analogique ou binaire, composée de la source de tension (11), de l'appareil externe connecté (8), du régulateur de courant (9) et du dispositif de mesure de courant (10), et qui établit une connexion en série pour le réglage passif du signal de courant analogique ou binaire, composée de l'appareil externe connecté (8), du régulateur de courant (9) et du dispositif de mesure de courant (10)

10. Appareil de mesure de terrain selon la revendication 9, **caractérisé en ce que** le dispositif conducteur de courant (26) comprend un commutateur (27) et un redresseur en pont (28), en particulier dans lequel le commutateur (27) est disposé électriquement entre le premier port (6) ou le deuxième port (7) et un premier port (28a) du redresseur en pont (28), et dans lequel le deuxième port (7) ou le premier port (6) est relié électriquement à un deuxième port (28b) du redresseur en pont (28), opposé au premier port (28a) du redresseur en pont (28).

11. Appareil de mesure de terrain (1) selon l'une quelconque des revendications 4 à 10, **caractérisé en ce que** la valeur théorique Iₛₒₗₗ pour le courant sur le trajet de courant de connexion est générée par le dispositif de mesure et de commande (5) sous la forme d'une tension théorique en convertissant une valeur théorique abstraite prédéfinie I_{soll,abs} pour le courant en un signal de tension modulé en largeur d'impulsion U_{PWM}, en lissant le signal de tension modulé en largeur d'impulsion U_{PWM} au moyen d'un filtre passe-bas (17) et en utilisant le signal de tension lissé U_{TP} indirectement ou directement comme une tension théorique qui représente la valeur théorique Iₛₒₗₗ pour le courant.

12. Appareil de mesure de terrain (1) selon l'une quelconque des revendications 1 à 11, **caractérisé en ce que** le signal de courant binaire est généré **en ce que** le dispositif de mesure et de commande (5) spécifie deux valeurs théoriques possibles seulement pour le régulateur de courant (9) en tant que valeurs théoriques possibles Iₛₒₗₗ pour le courant sur le trajet de courant de connexion, à savoir une valeur théorique LOW I_{soll,low} et une valeur théorique HIGH I_{soll,high}, les deux valeurs théoriques représentant les deux valeurs du signal de courant binaire.

13. Appareil de mesure de terrain (1) selon la revendication 12, **caractérisé en ce que** la valeur théorique HIGH I_{soll,high} pour le signal de courant binaire dans le dispositif de mesure et de commande (5) est générée sous la forme d'un signal de tension HIGH U_{high}(I_{soll,high}) sur une ligne d'alimentation (18) vers le régulateur de courant (9), **en ce que** la valeur théorique LOW I_{soll,low} pour le signal de courant binaire dans le dispositif de mesure et de commande (5) est générée sous la forme d'un signal de tension LOW U_{low} (I_{soll,low}), et **en ce que** la ligne d'alimentation (18) jusqu'au régulateur de courant (9) est tirée du signal de tension HIGH U_{high} vers le signal de tension LOW U_{low} par la fermeture d'un commutateur à semi-conducteur (19).

14. Appareil de mesure de terrain (1) selon l'une quelconque des revendications 1 à 13, **caractérisé en ce que** le signal de courant binaire est lu, **en ce que** la valeur réelle Iᵢₛₜ détectée par le dispositif de mesure de courant (10) sur le trajet de courant de connexion du courant sur le trajet de courant de connexion est lissée au moyen d'un filtre passe-bas (20) et en particulier amplifiée au moyen d'un amplificateur (21), et la valeur réelle Iᵢₛₜ lissée et en particulier amplifiée est amenée pour évaluation à un comparateur (22) et/ou à une entrée analogique (24) d'un microcontrôleur (23) du dispositif de mesure et de commande (5).

15. Appareil de mesure de terrain (1) selon la revendication 14, **caractérisé en ce que** le signal de sortie fourni par le comparateur (22) est amené à l'entrée numérique (25) du microcontrôleur (23) du dispositif de mesure et de commande (5) pour une évaluation supplémentaire.
